# EUROPEAN PATENT APPLICATION

(11) **EP 2 933 838 A1**
(43) Date of publication of application: **21.10.2015**
(21) Application number: 14305567.1
(22) Date of filing: 16.04.2014
(51) Int. Cl.: H01L 27/102, H01L 27/112

(54) **Method of making a three dimensional printed memory**

(71) Applicant: Thomson Licensing, 92130 Issy-les-Moulineaux (FR)
(72) Inventor: Blawat, Meinolf, 30659 Hannover (DE); Hütter, Ingo, 30982 Pattensen (DE)
(74) Representative: Thies, Stephan

(57) **Abstract**

Proposed is a method of making a three-dimensional printed memory (3D-P) for long term data storage. The method comprising
a) volume printing a base layer (3) on a substrate (2);
b) volume printing a first level (4) of address lines (5) above said base layer (3);
c) volume printing a data-coding layer (6) above said first level (4) of address lines (5) and volume printing individual data elements (7) to said data-coding layer (6);
d) volume printing a second level (8) of address lines (9) above said data-coding layer (6);
e) volume printing a base layer (3) above said second level (8) of address lines (9);
f) repeating steps a)-e) to form another memory level.

## Description

### FIELD

The invention is directed to a method of making a three-dimensional printed memory.

### BACKGROUND

In film productions huge amounts of media data are generated that need to be securely stored over long periods of times, e.g. decades or even longer. Today the gathered and generated media data is stored on hard disc drives. Since these hard disc drives have only a guaranteed life-span of about five years, just to leave the data on these hard disc drives is in no way sufficient in order to archive these data for long times. However, today there is no reliable long-term mass storage technology and storage media available at reasonable cost that makes direct archiving of digital data possible. All mass storage technologies commonly used for archiving purposes, like tape drives, DVD and Blu-Ray recorders, as well as some less common optical storage discs like holographic discs or super resolution optical discs, do not show the needed longevity of several decades, let alone of hundreds of years, as well as lead to high maintenance costs since the stored data has to be copied to new media when the life-span of the storage media is coming to an end.

US 2013/0056798 A1 discloses a three-dimensional printed memory in which several layers are stacked one over the other. For each layer a data mask is used to transfer a data pattern on a previous layer, as is used in conventional mask programmed read only memory production. In view of the cost of the data mask Such three-dimensional printed memory is only suitable for mass distribution of mass contents, but is not cost efficient for long term storage purposes, where only a small number of storage media, even down to a single storage medium, is needed.

### SUMMARY

It is desired to find a reliable long-term archiving technology, which causes only low total owner costs, which means cost of the storage medium as well as the management of the storage medium.

According to the invention a three-dimensional printed memory is made by volume printing. The inventive method comprises
- volume printing a base layer on a substrate,
- volume printing a first level of address lines above or onto said base layer,
- volume printing a data coding layer above or onto said first level of address lines and volume printing individual data elements to said data coding layer,
- volume printing a second level of address lines above or onto said data coding layer, and
- repeating the previous steps to form another memory level.

This has the advantage that there is no need to produce data masks. Instead, address lines and data coding layer are directly printed according to the desired data pattern. Compared to mask programmed read only memory devices, the size of the data elements and address lines according to the invention is big. This has the advantage of longevity. The larger a data element is, the less decay over time occurs due to long time changes on molecular or atomic size scale. Such structural or chemical changes over time occur for example due to natural radiation, temperature effects or chemical disintegration. Depending on properties of the use materials and/or characteristics of the volume printing apparatus used, the mentioned layers are volume printed directly onto each other, or they are printed above each other with a separating layer or connecting layer in-between. A separating layer has the advantage of separating the volume printed materials from each other while the newly applied volume element is still liquid and/or during the hardening time, so as to prevent mixing where it is not appropriate. A connecting layer has the advantage of aiding the sticking together of the different layers to each other, especially in case of differing material properties.

Preferably the data coding layer is a resistor diode matrix. Resister diodes are well known storage elements with reliable characteristics. They can thus easily be employed. Alternatively, address lines and data coding elements are made of materials that are transparent to light while the other elements of the printed memory are made from non-transparent material. This allows reading of the data by using light scanning and light detectors, which are well-known and readily available elements and can thus be easily applied for the read out purpose of such printed memory.

According to one embodiment of the invention the resistor diodes are formed by cuboids of P-type conductive material on top of a layer of n-type conductive material. Such materials are already available for 3D-printing and can thus be implemented immediately without need to search for or development of other material combinations that might have other advantages e.g. that might require less volume.

Cuboids having a volume about four orders of magnitude larger than the average size of commonly used flash memory cells have the advantage of longevity, as already mentioned above, and of easy connectivity as no nano-scaled mechanical contacts need to be applied.

According to another advantageous embodiment the cuboid's "cross section" has one of a set of different cross section values. This has the advantage that different cross-sections can be easily produced and for each different cross-section value a different resistivity exists and thus several bits can be stored within the volume of one cuboid.

In a further advantageous embodiment each of the cuboids consists of one material out of a set of different conductive materials. This has the advantage that the smallest volume of a data element possible can be used, and at the same time, due to different conductivity properties of the different materials, additional data can be coded depending on the number of different conductive materials.

In a further embodiment each of the cuboids has a set of different height values. Also different heights lead to different electrical conductivity/capacity values which are used to increase the storage capacity. Although a larger volume is needed therefore, an optimized ratio between volume per storage element and differentiation of values per storage element can be applied, adapted on the material properties used.

According to the invention a connector element for establishing a connection of the three-dimensional printed memory device to another, separate device, is established by volume printing. The separate device may be a data reading device or a storage device. The connection is at least one of the following: Mechanical connection to affix the printed memory in the separate device, e.g. for reading data or for storage of printed memory without data connection. Advantageously connector elements for establishing an electrical connection, e.g. for power supply and/or data reading are provided. A very simple data reading connection is established if each address line terminates the surface of the three-dimensional printed memory where it can be connected from outside. In a similar way an optical connection for data reading is foreseen. The electrical and/or optical connection is for example established via direct mechanical/conductive connection or remote via, for example, electromagnetic waves. The connector element is preferably arranged at a surface of the device, which allows direct connection, or in the interior of the remote device, in case remote connection is used.

A three-dimensional printed memory device is preferably made according to the method claims. An advantageous embodiment provides for the three-dimensional printed memory device having the same size and connection element arrangement as commonly used memory devices. For example USB-memory devices, SIM-cards, compact flash cards etc. are used to model the size and connection element arrangement of the printed memory device which then can be easily read using commonly used reading devices.

According to the invention the three-dimensional printed memory device is used for long term data storage. This has the advantage that the production costs for the three-dimensional printed memory device are low compared to mask printing for low batch numbers. Further the comparatively "large" size of the storage elements increases the longevity of such printed memory device. These advantages are even more obvious in case of individualized long term data storage where, according to state of the art, an expensive data mask would be needed for each individual printed memory device.

A device adapted to perform the method steps according to the method claims is advantageously used to produce a printed memory device according to the invention.

According to the invention it is suggested to deploy so-called 3D-printers in order to store data to be archived. These printers make it possible to form three-dimensional objects out of various materials, for instance out of plastics. Similar to the technique of common ink printers, where a single layer of ink is printed, thin layer on thin layer of material is consecutively extruded using a 3D printer until the final 3D-object has been formed. Such modern 3D printers can print with several different materials at the same time, which is a process that can be compared to colour ink printers.

These various plastic materials, for instance plastic polymers, not only may have different electric resistances, but can also show p-type and n-type electric conduction, similarly as doped germanium and silicon. Consequently, conductive stripes, resistors as well as diodes can be formed. This makes it possible to print out more complex electric circuitries, like for example resistor-diode matrices. Resistor-diode matrices, or shortly diode-matrices, can be used to store information. According to the data to be stored, the cross-sections of a matrix are connected by a series connection of a resistor and a diode. For instance, a thus connected cross-section may represent a logical "1", while a not connected cross-section is interpreted as a logical "0". Currently available 3D printers with minimal printable structures of 0.1 mm and maximum printable body size of 50 cm in each dimension lead to about 1GByte of data.

Advantages of employing three dimensional printed memories for long term data storage are:
- The used plastics material are hard-wearing. They resist acid chemicals, are non-fading, water and vapour can do no harm to them, just to mention some of their features.
- The warehousing requires no expensive cooling, no special demands on humidity control, and no unusual fire protection measures.
- The applied technologies are well known, while the degree of complication and complexity is comparably low.
- All components are available from the shelf.
- The technology and plastics as the storage media are cheap. The total owner costs of 3D-Printer Storage archives are low.

Further advantages and exemplary embodiments of the invention are described in the following by means of Figures.

### BRIEF DESCRIPTION OF DRAWINGS

The Figures show:
- Fig. 1:: Diagrammatical view of some layers of a printed memory device
- Fig. 2:: Diagrammatical view of a resistor diode matrix
- Fig. 3:: 3D-printing machine
- Fig. 4:: Work principle of a 3D-prining machine
- Fig. 5:: Diagrammatical view of a base layer with address layer
- Fig. 6:: Diagrammatical view of base layer, first level address layer, data coding layer
- Fig. 7:: Diagrammatical view of second level address layer (separate and overlaid on previous layers)
- Fig. 8:: Diagrammatical view of printed memory showing cuboids representing data coding layer
- Fig. 9:: Diagrammatical view of two data coding layers
- Fig. 10:: Diagrammatical view of a connector element
- Fig. 11:: Diagrammatical view of a reading operation
- Fig. 12:: Flow chart of inventive methods
- Fig. 13:: Diagrammatical view of a resistor diode connection

### DESCRIPTION OF EMBODIMENTS

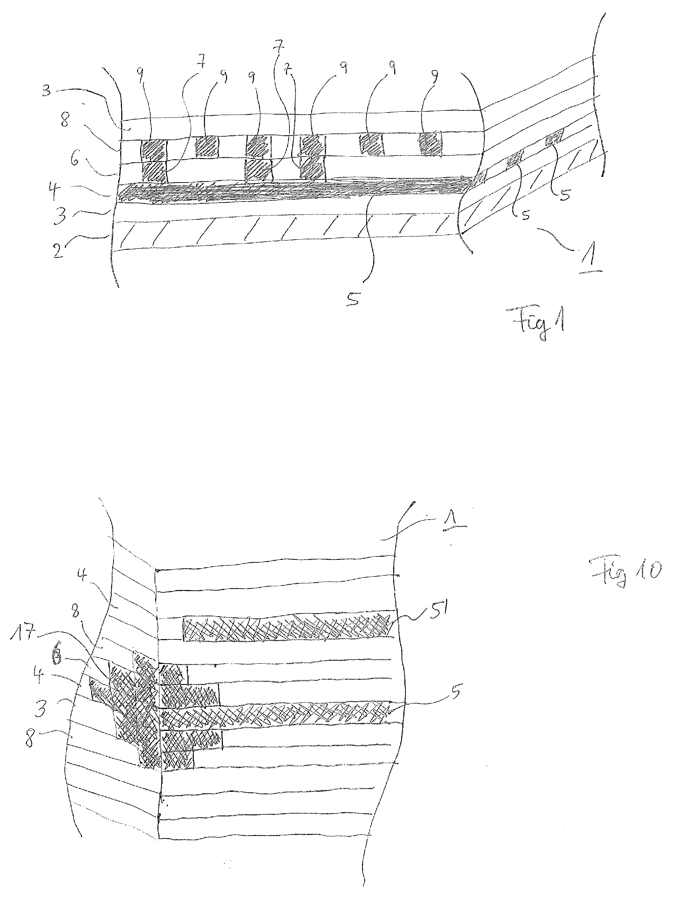

Fig. 1 shows the layer structure of a printed memory device 1 according to the invention. On a substrate 2 a base layer 3 is arranged. On top of base layer 3 a first level 4 of address lines 5 is arranged. Above the first level 4 of address lines 5 a data coding layer 6 is arranged by means of volume printing. The data coding layer 6 is provided with individual data elements 7. Above the data coding layer 6 a second level 8 of address lines 9 is volume printed. Above the second level 8 of address lines 9 another base layer 3 is arranged. The succession of different layers is repeated multiple times (not shown here). The substrate 2 may either become part of the printed memory device or may be removed after the volume printing process is finished. The address lines 5 of first level 4 extend in a right angle to the address lines 9 of second level 8, so that the data elements 7 connect the two types of address lines 5, 9.

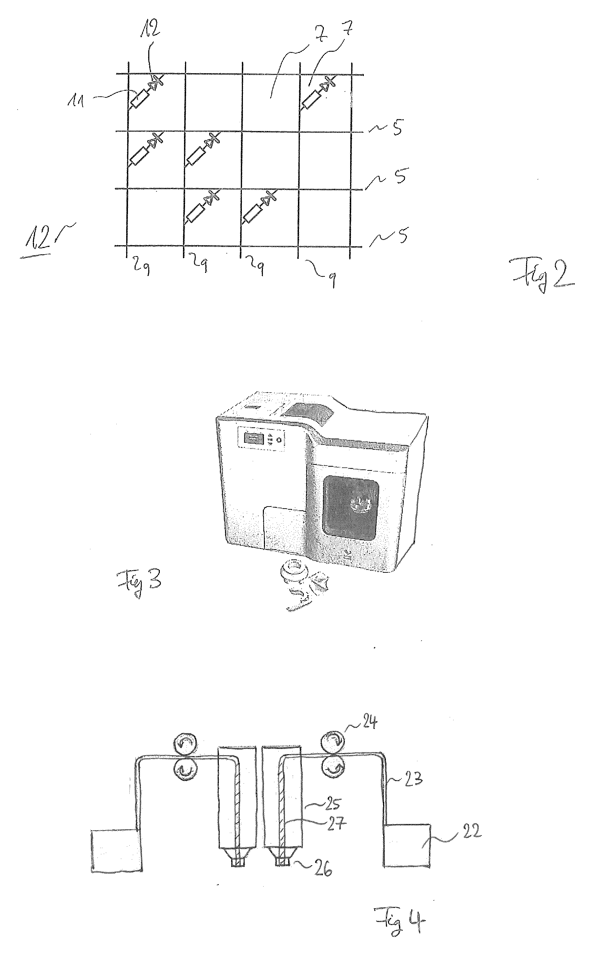

Fig. 2 shows a diagrammatical view of a resistor diode matrix 10. First level address lines 5 and second level address lines 9 are shown in a top view. The distance of levels is not visible in this view. Data elements 7 are represented by the rectangles defined by the address lines 5, 9 and either represent a logical 1 if they consist of a resistor 11 and a diode 12 arranged in series connection between address lines 9 and address lines 5. Or they represent a logical zero if no connection consisting of resistor 11 and diode 12 is arranged in the area of a data element 7.

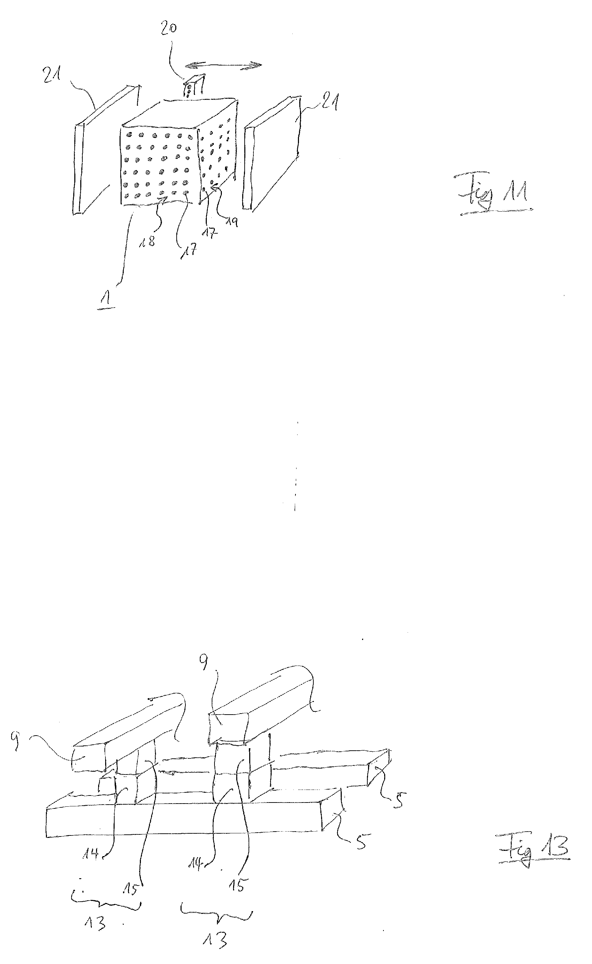

Fig. 13 shows a diagrammatical view of a resistor diode connection. In the lower part of Fig. 13 two address lines 5 are diagrammatically shown. The address line 5 in the front has arranged on its top two cuboids 13, each consisting of a layer of p-type conductive material 14 on top of which a layer of n-type conductive material 15 is arranged. Atop of the cuboids 13 two address lines 9 are shown. Non-conductive filler material that is arranged between the mentioned elements is not shown here in order to increase visibility. In this example the second address line 5 in the back part of the drawing has no data element 7 shown in this part of the printed memory device. The cuboids 13 have a size that is at least a factor of 10.000 larger than the size of usual flash memory cells (20nm).

One embodiment of the invention diagrammatically depicted in Fig. 13 deals with volume printed three-dimensional stacked layers of resistor-diode matrices. In order to simplify the explanation of this embodiment, several restrictions will be assumed without loss of generality.

The resistor-diodes are formed by cuboids 13 of p-type conductive material 14, on which tops a layer of n-type conductive material 15 is volume printed. Electrically, these cuboids 13 can be considered as series connection of a resistor and a diode.

Information bits are represented by connections of conductive stripes 5, 9 forming a matrix. The horizontally aligned stripes are volume printed on the base layer, while the horizontal stripes are volume printed below the next base layer, which can be regarded as a top layer for the current data coding layer 6. The lowest base layer may be arranged on a substrate, or the substrate itself may form the lowest base layer.

Cuboids representing a logical "1" are all identical. These cuboids consist of p-type conductive material 14. On top of each of these cuboids a layer of n-type conductive material 15 is volume printed.

The volume printed cuboids are regularly aligned on the points of intersections of a three dimensional rectangular lattice or matrix pattern.

Remark: In the very simply model described here, the cuboids representing a logical "0" could be left out completely. However, in order to show the possible variations more clearly they will be included in the explanations and drawings described in the following.

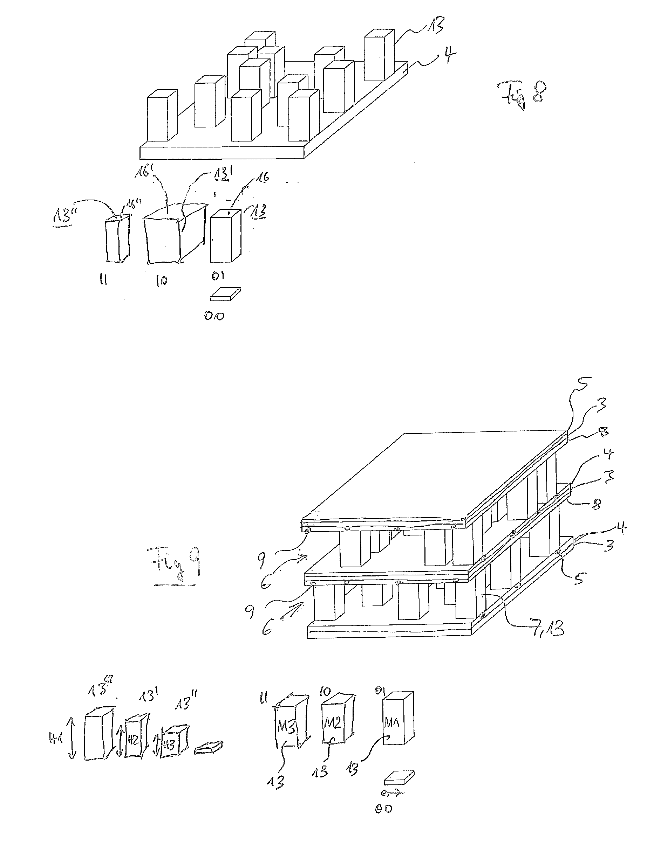

Fig. 8 shows a diagrammatical view of a printed memory showing cuboids 13 representing a data coding layer. In the upper part the cuboids 13 are arranged on first level layer 4 in which the address lines 5 are not shown. In the lower part of Fig. 8 in the lower part cuboids 13, 13' and 13" are shown, having different cross-section values 16, 16', and 16" . As can be seen, the top surface of cuboid 13 has a medium size cross-section value 16. The cross-section value 16' of cuboid 13' is much larger than cross-section value 16, while cross-section value 16" of cuboid 13" is much smaller. Together with the free space, where no cuboid is arranged, four different logical values can be represented by these three types of cuboids. This is indicated by the binary values 11_{b} assigned to cuboid 13" , 10_{b} to cuboid 13' and 01_{b} assigned to cuboid 13. No cuboid represents the binary value 00_{b}.

Fig. 9 shows a diagrammatical view of two data coding layers. Base layer 3, first level 4 of address lines 5 and second level 8 of address lines 9 are shown here extremely thin compared to the exaggerated thickness of the data coding layers 6. From the data coding layer 6 only the data elements 7, shown here as cuboids 13, are shown. In the lower part of Fig. 9 different types of cuboids 13 consisting of different types of conducting material M1, M2, M3 are shown. With three different materials and the insulating material representing the binary values 00_{b}, again four binary values can be represented.

Also shown in the lower part of Fig. 9 are cuboids 13, 13' and 13" consisting of the same material but having different heights H1, H2, H3. Due to the different height values H1, H2, H3, different capacities are generated which result in different electrical properties that represent three different values.

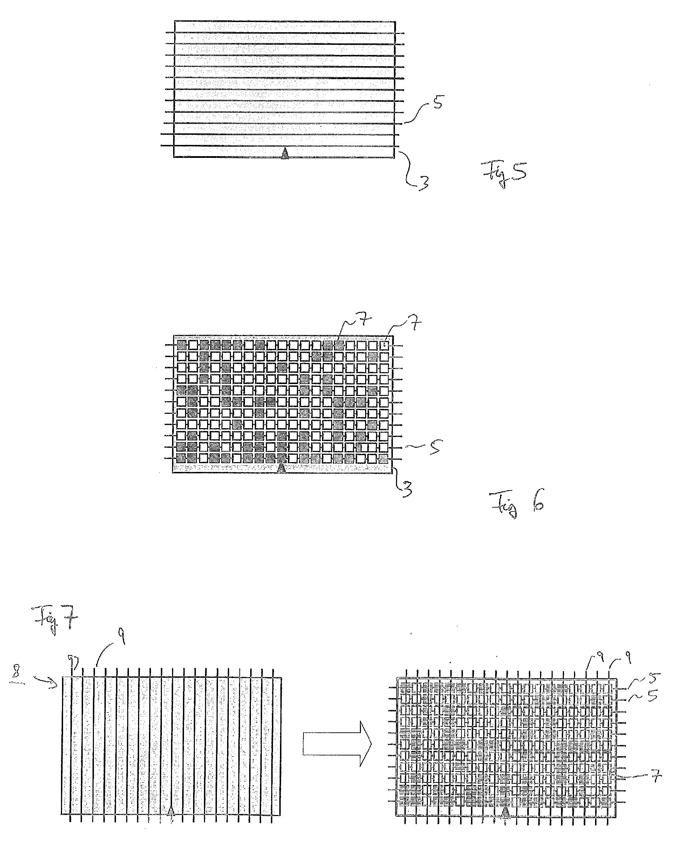

Fig. 5 shows a diagrammatical top view of base layer 3 with address lines 5.

Fig. 6 shows a diagrammatical view of base layer 3, address lines 5 and atop of these data elements 7. The data elements 7 represented by black dots indicate the top view on a cuboid 13 that represents a logical 1. The white dots represent data elements 7 where no cuboid of conductive material is arranged and thus they represent a logical 0.

Fig. 7 shows in the left part a diagrammatical view of a second level 8 layer of address lines 9, which is in the right part shown overlaid to the layer stack shown in Fig. 6.

Fig. 10 shows a diagrammatical view of a connector element 17. On the left side of Fig. 10 the surface of the printed memory device 1 is visible where the connector element 17 extents over the first level 4 layer of address lines 5, the base layer 3 below the first level layer 4 and the second level 8 layer below base layer 3. The connector element 17 extents also over an area of the data coding layer 6 above first level 4 and second level 8 above data coding layer 6. A similar extension as described here in heights also exists in widths. This means that connector element 17 has a comparatively large cross section compared to the cross section of the address lines 5 in the inner part of the printed memory device 1. The connector element 17 is thus easily connectable from the outside either with direct contact connection or, for example, in the case of a light conducting material of address lines 5, by a remote connection. For example, a beam of light might be focused on connector element 17. In case of direct contact a tip of an electrode is brought in contact with connector element 17. Four layers above the address line 5 shown here, another address line 5' in another first level 4 layer is shown. It does not extend until the surface of the memory device but extends to the opposite side of the printed memory device 1. At the opposite side address line 5' terminates in a connector element (not shown here) while the neighbouring address line 5 does not extend to the opposite surface. By means of this arrangement all address lines 5, 5' can extend to the enlarged diameter connector element 17, one half is accessible at one side of the printed memory device 1, the other half is accessible at the opposite side. Similarly, the address lines 9 are provided with connector elements at two further sides of the printed memory device 1.

Fig. 11 shows a diagrammatical view of a reading operation for a printed memory device 1. The printed memory device 1 is shown as a cube having a front side 18 with connector elements 17 in which address lines 9 terminate and a right side 19 in which connector elements 17 of address lines 5 terminate. In this example the address lines 5, 9 and the data elements 7 consist of light transmitting material, while the remainder of the printed memory device 1 consists of intransparent material. The reading device is provided with a source 20 arranged in the back of printed memory device 1 and another source (not shown here) in front of printed memory device 1. At the left and the right side of printed memory device 1 a drain element 21 is arranged. In case that the source 20 consists of light sources, the drains 21 are optical sensor arrays. The source 20 moves from the left side to the right side of the printed memory device 1 thus successively illuminating all of the 50% address lines 9 that terminate in connector elements 17 at the rear part of the printed memory device 1. Similarly the other, not shown source moves in the front and successively illuminates the other 50% of address lines 9. The sensor elements 21 detect light that goes through the transparent data elements 7 and exits the address lines 5 on connector elements 17. By this arrangement reading the data out of printed memory device 1 can be done in a very simple way. Similarly source 20 and drain 21 can be provided with electrical connector elements to read out printed memory device 1 in case of electrically conductive address lines 5, 9 and data elements 7.

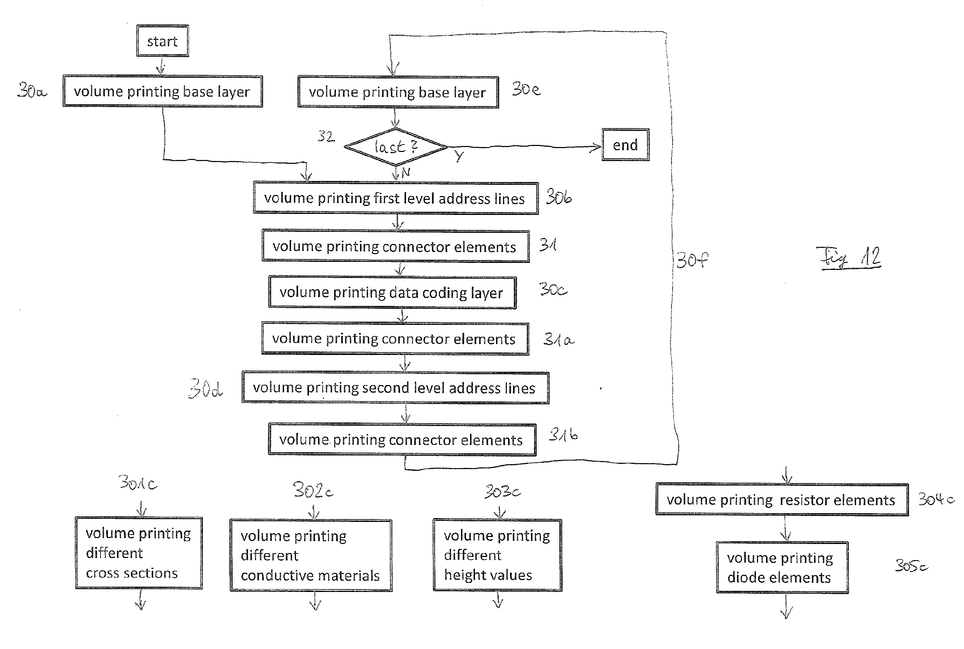

Fig. 12 shows a flow chart of inventive methods. The method starts with step 30a by volume printing a base layer 3 on a substrate 2. Depending on the 3D-printing machine the substrate may be a substrate that later on forms part of the three-dimensional printed memory, but may also be a substrate that, after volume printing of the layers has finished, can be removed from the volume printed three-dimensional printed memory. In step 30b a first level 4 of address lines 5 is volume printed upon the base layer 3. Depending on the design of the three-dimensional printed memory a step of volume printing connector elements may take place during the volume printing of the first level address lines of step 30b. In step 30c volume printing of a data coding layer takes place. Here, too, volume printing of connector elements of step 31a takes place depending on the design. In step 30e volume printing of a second level 8 of address lines 9 takes place. Here, too, volume printing of connector elements may take place during volume printing of the second level layer. It follows the volume printing of a next base layer upon the second level layer in step 30e. Here, too, volume printing of connector elements may take place at the same time (not shown here). In step 32 it is checked, whether the latest printed base layer is the last layer to be volume printed. If yes, then the method ends, else it is continued with step 30b.

The start and end points may include volume printing of cover layers or protective layers, depending on the 3D printing method and materials use. The step 30c of volume printing a data coding layer may include one of the following steps 301c to 304c. Step 301c consists of volume printing of individual data elements with different cross sections. Step 302c consists of volume printing of individual data elements 7 using different conductive materials. Step 303c consists of volume printing of individual data elements 7 having different height values. Another preferred embodiment of volume printing individual data elements 7 consists of first volume printing resistor elements 11 in 304c and upon these, in a next layer, volume printing of diode elements 12 in step 305c.

In step 30a or 30e a base layer 3 is volume printed, which has equidistant conductive stripes as address lines 5 at its top surface. The stripes are part of a first level 4 layer, and can be seen as the horizontal lines of the finally resulting three-dimensional lattice or matrix structure, or as the vertical lines respectively. Fig. 5 illustrates the base layer 3 with the conductive stripes of first level 4.

In step 30c the information representing cuboids 13, which are electrical series connections of resistors 11 and diodes 12, are volume printed on the intersections of the finally resulting matrix structure. A logical "1" is represented by a cuboid or data element 7, while a logical "0" is represented if no cuboid is volume printed. In this case usually a non-conductive filler material is printed instead. Such filler material is also used as filler material between two data coding elements 7. Fig. 6 shows the top view of an exemplary 3D-printout.

In step 30d a second level 8 layer, or top board, with equidistant conductive stripes as address lines 9 is volume printed on top of the columns while the stripes are oriented rectangular to the address lines 5 of the first level 4 layer so that a lattice or matrix is resulting together with the volume printed data elements 7. Since the data elements 7 are electrical series connections of a resistor 11 and a diode 12, the data elements 7, or cuboids, can easily be detected. Fig. 7 illustrates the first printed out 3D -storage layer of cuboids.

Consecutively, on the first 3D-storage layer stack, a further 3D-storage layer stack is printed, see step 30f, which includes volume printing an insulating base layer 3. This stacking process is continued until the volume printing capacity (maximum number of volume printable layers, depending on the volume printing device) is reached or until the data storing is completed.

The volume printed structures can be quite small, which means that storage densities of printed storages are high. Figure 3 shows such a standard 3D-printer for volume printing plastic bodies. The working principle is illustrated in Figure 4.

Fig. 4 shows the work principle of a 3D printing machine. From a material cartridge 22 a filament 23 of 3D printing material is transported to a heater block 25 via drive wheels 24. In the heater block 25 the filament 23 is heated and the molten filament 27 is led to a printing tip 26 from where small volume units of the molten material can be applied to a 3D printing object (not shown here). Several such units are used to print several different materials on the three-dimensional object. Two of such units are shown in Fig. 4.

The stored information can easily be retrieved. Regarding the here considered simplest example of 3D-storage the electrical current between two mutual rectangular matrix stripes (address lines 5 and 9) is measured. If an electric current is detected, then a data element 7 is detected, which means a logical "1" has been stored. The contrary holds for a logical "0".

In addition, structures are possible that are more complex. For example, the cross-section of the cuboids can vary. For example, four different cross sections can represent two bits of information, as shown in the lower part of Fig. 8. In order to retrieve stored information in this case, the actual resistances of the volume printed cuboids 13, 13', 13" have to be measured.

The diode 12 on top of each resistor 11 can be volume printed in several ways. A further variant to the one used in the preceding explanation is for example that on top of the resistors 11 firstly a p-type polymer layer is volume printed followed by an n-type polymer layer. According to another embodiment the conductive stripes that form address lines 9 of the mentioned second level 8 layers are consisting of n-type conductive polymers, and the data elements 7 are volume printed with p-type conductive polymers. Thus also diodes are formed at the contact points.

According to another embodiment indicated in Fig. 9 several conductive materials M1, M2, M3 are applied with different electrical resistances. Again, the resistances of the volume printed cuboids 13 have to be measured when retrieving data. Of course, all parameters mentioned can also be combined thus increasing the number of bits represented by each cuboid 13. Fig. 8 and Fig. 9 illustrate the here described volume printed storage in three-dimensional views. In fact, using a 3D-printer in the described way results in a volume printed 3D One-Time-Programmable (OTP) storage device.

## Claims

1. A method of making a three-dimensional printed memory (3D-P), comprising
a) volume printing a base layer (3) on a substrate (2);
b) volume printing a first level (4) of address lines (5) above or onto said base layer (3);
c) volume printing individual data elements (7) forming a data-coding layer (6) on said first level (4) of address lines (5;
d) volume printing a second level (8) of address lines (9) above or onto said data-coding layer (6);
e) volume printing a base layer (3) above or onto said second level (8) of address lines (9);
f) repeating steps a)-e) to form another memory level.

2. Method according to claim 1, wherein the data-coding layer (6) of step c) is a resistor-diode matrix (10).

3. Method according to claim 2, wherein the resistor-diodes (11,12) are formed by cuboids (13) of p-type conductive material (14) on top of which a layer of n-type conductive material (15) is volume printed.

4. Method according to claim 3, wherein the cuboids (13) have a volume s³ where s>10⁴*t where t is the average size of flash memory cells.

5. Method according to claim 3, wherein each of the cuboids (13,13',13") has one of a set of different cross section values (16,16',16").

6. Method according to claim 3, wherein each of the cuboids (13) consists of a set of different conductive materials (M1,M2,M3).

7. Method according to claim 3, wherein each of the cuboids (13,13',13") has a set of different height values (H1,H2,H3).

8. Method according to one of the preceding claims, having the further step (31, 31a, 31b) of volume printing a connector element (17) for establishing a connection of the three dimensional printed memory device (1) to another separate device.

9. Three dimensional printed memory device (1) made by the method according to one of claims 1 to 8.

10. Three dimensional printed memory device (1) according to claim 9, wherein the device (1) has the same size and connector element (17) arrangement as commonly used memory devices.

11. Use of the three dimensional printed memory device (1) according to one of claims 9 to 10 for long term data storage.

12. Use of the device according to one of claims 9 to 10 for individualized long term data storage.

13. Device adapted to perform the steps according to one of claims 1 to 8.
